Europäisches Patentamt

European Patent Office

Office européen des brevets

(11) Veröffentlichungsnummer: **0 048 885**
A2

## (12) EUROPÄISCHE PATENTANMELDUNG

(21) Anmeldenummer: 81107268.5

(22) Anmeldetag: 15.09.81

(51) Int. Cl.³: **H 03 F 3/193**, H 03 F 1/56

(30) Priorität: 30.09.80 DE 3036885

(43) Veröffentlichungstag der Anmeldung: 07.04.82
Patentblatt 82/14

(84) Benannte Vertragsstaaten: **DE FR GB IT**

(71) Anmelder: **SIEMENS AKTIENGESELLSCHAFT Berlin und München, Postfach 22 02 61, D-8000 München 22 (DE)**

(72) Erfinder: **Petz, Felix, Dipl.-Phys., Balanstrasse 88, D-8000 München 90 (DE)**

(54) **Transistor-Schaltung.**

(57) Die Erfindung betrifft eine Transistor-Schaltung mit erhöhtem Ausgangswiderstand, bei der wenigstens zwei Transistoren ($T_1$, $T_2$) in Reihe liegen. Zwischen den Eingangs- und/oder Steuerelektroden der Transistoren ($T_1$, $T_2$) befinden sich Widerstände oder Dioden ($D_i$), die den Ausganswiderstand der Schaltung erhöhen, um so eine Stromquelle mit hohem Innenwiderstand zu schaffen.

SIEMENS AKTIENGESELLSCHAFT · Unser Zeichen 0048885
Berlin und München VPA

80 P 1 1 6 5 E

## Transistor-Schaltung

Die Erfindung betrifft eine Transistor-Schaltung mit erhöhtem Ausgangswiderstand, bei der wenigstens zwei Transistoren mit parallelen Steuerelektroden in Reihe liegen.

Beispielsweise bei aktiven Autoantennen, Breitband- und Antennenverstärkern, selektiven Verstärkern mit hoher Güte und Operationsverstärkern werden allgemein Stromquellen, das heißt Schaltungen mit der Bedingung $R_i \rightarrow \infty$ ($R_i$ = Innenwiderstand), aktive Lasten mit hoher Verstärkung und schnelle Spannungs-Strom-Wandler bei möglichst voller Integrationsmöglichkeit, angestrebt.

Es ist nun Aufgabe der Erfindung, eine solche Transistor-Schaltung zu schaffen.

Diese Aufgabe wird erfindungsgemäß dadurch gelöst, daß zwischen den Eingangs- und/oder Steuerelektroden der Transistoren Einrichtungen vorgesehen sind, die den Ausgangswiderstand der Schaltung steigern.

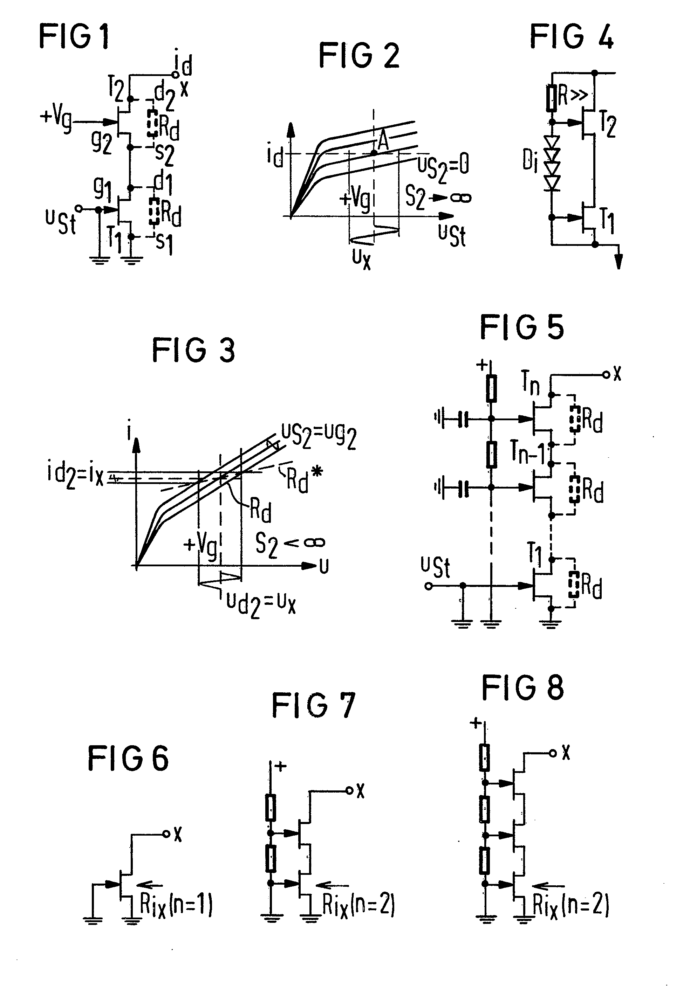

In Fig. 1 ist das Prinzipschaltbild einer einfachen Stromquelle gezeigt. Am Gate-Anschluß $g_2$ eines Feldeffekttransistors $T_2$ liegt eine Spannung $+V_g$, so daß ein vorgeschalteter Feldeffekttransistor $T_1$ im Bereich der Sättigung arbeitet, wie dies in Fig. 2 gezeigt ist, in der der Drain-Strom $i_d$ in Abhängigkeit von der Steuerspannung $u_{St}$ für verschiedene Source-Spannungen $U_{s2}$ an Source $S_2$ des Transistors $T_2$ aufgetragen ist. Der Transistor $T_2$ arbeitet dabei als Source-Folger, da am

Kot 1 Dx / 29.09.1980

Source-Anschluß $s_2$ des Transistors $T_2$ bei $S_2 \longrightarrow \infty$ ($S_2$ = Steilheit des Transistors $T_2$) die gleiche Wechselspannung wie am Gate-Anschluß $g_2$ liegt, nämlich 0 V. Die Transistoren $T_1$ und $T_2$ werden als ideale Transistoren mit $R_i \longrightarrow \infty$ angesehen, denen jeweils extern ein Widerstand $R_d$ parallel geschaltet ist, um so reale Transistoren zu erhalten.

Liegt nun am Gate-Anschluß $g_2$ des Feldeffekttransistors $T_2$ ein Nullpotential vor, so wird mit Hilfe des als Source-Folger betriebenen Feldeffekttransistors $T_2$ auch am Source-Anschluß $s_2$ wechselspannungsmäßig der Wert 0 V erzwungen. Der Transistor $T_1$ erfährt dann keine Drainspannungsänderung, auch wenn an einem Anschluß x eine Wechselspannung u anliegt. Der dabei entstehende Strom durch den Widerstand $R_d$ wird nämlich durch eine entsprechende Regelung des Transistors $T_2$ aufgefangen, so daß der Transistor $T_1$ gemäß Fig. 2, in der die Abhängigkeit des Drain-Stroms $i_d$ von der Spannung u für verschiedene Spannungen $u_{d2}$ am Drain-Anschluß des Transistors $T_2$ dargestellt ist, in einem Arbeitspunkt A verbleibt, was bedeutet, daß der Strom am Anschluß x konstant ist, was $R_i \longrightarrow \infty$ trotz $R_d < \infty$ bedeutet.

Unter tatsächlichen Betriebsbedingungen ist die Steilheit $S_2 < \infty$, was zu $R_{ix} < \infty$ führt.

Bei einer tatsächlichen Schaltung ist die Steilheit $S_2 < \infty$, was zu $R_{ix} < \infty$ führt.

Eine Kleinsignal-Ersatzschaltbildrechnung liefert dann:

$$R'_{ix} = R'_d \left( S_2 + \frac{2}{R'_d} \right) \qquad (1)$$

0048885

80 P 1165 E

mit:

$R'_{ix}$ = verbesserter Ausgangswiderstand gemäß Schaltung der Fig. 1, und

$R'_d$ = natürlicher Ausgangswiderstand der Transistoren $T_1$ und $T_2$.

Fig. 3 zeigt die in einer realen Schaltung auftretenden Verhältnisse; die Spannung am Drain-Anschluß des Transistors $T_1$ verbleibt nicht wie in Fig. 2 in einem Arbeitspunkt A, sondern wandert vielmehr entlang einer Geraden $R^*_d$.

Über den Gate-Anschluß $g_1$ des Transistors $T_1$ (vergleiche Fig. 1) kann die Stromquelle, nämlich der Transistor mit hohem Ausgangswiderstand, gesteuert werden, wenn dieser Gate-Anschluß $g_2$ nicht mit Masse verbunden ist, sondern mit der Steuerspannung $u_{St}$ beaufschlagt wird.

Fig. 4 zeigt ein Ausführungsbeispiel der Erfindung mit einer aktiven Last. Ein Widerstand $R_\gg$ soll dabei möglichst hochohmig sein, da dieser Widerstand dem Innenwiderstand $R_i$ der aktiven Last aus dem Transistor $T_2$ parallel liegt. Dioden $D_i$ erzeugen den erforderlichen Gleichspannungshub, der den Transistor $T_1$ in Sättigung bringt. Die Schaltung der Fig. 4 arbeitet im übrigen grundsätzlich in der gleichen Weise wie die Schaltung der Fig. 1.

Um den Ausgangswiderstand weiter zu erhöhen, können auch zwei Transistoren hinereinander geschaltet werden, wie dies in Fig. 5 gezeigt ist. Im Unterschied zur Gleichung (1) liefert die Kleinsignal-Ersatzschaltbildrechnung dann für n = 3, also drei in Serie geschaltete Transistoren

$$R_{ix} (n = 3) = R_d^2 \left\{ (S_2 + \frac{2}{R_d}) (1 + S_3 R_d) + \frac{1}{R_d} \right\} \qquad (2)$$

In ähnlicher Weise kann auch der Innenwiderstand der aktiven Last vergrößert werden.

Die Fig. 6, 7 und 8 zeigen jeweils reale Beispiele, wobei angenommen wird, daß alle Transistoren gleich sind und $S = 2 \cdot 10^{-2} \Omega^{-1}$ sowie $R_a = 1 k\Omega$ vorliegen. Für die Beispiele der Fig. 6 bis 8 gelten dann jeweils:

$$R_{ix} (n = 1) = R_d = 1 k\Omega \text{ (Fig. 6)}$$

$$R_{ix} (n = 2) = 22 k\Omega \qquad \text{(Fig. 7) und}$$

$$R_{ix} (n = 3) = 463 k\Omega \qquad \text{(Fig. 8)}.$$

In einer Weiterbildung der Erfindung soll auch der Ausgangswiderstand einer Transistor-Schaltung mit GaAs-Feldeffekttransistor erhöht werden.

Auch diese Transistor-Schaltung arbeitet grundsätzlich entsprechend dem Beispiel der Fig. 1. Der Spannungshub für den Transistor $T_2$ wird jedoch nicht mittels Widerständen (vergleiche Fig. 1) oder Dioden und Widerständen (vergleiche Fig. 4) vorgenommen, sondern vielmehr automatisch durch eine Serienschaltung von Transistoren mit unterschiedlicher Steilheit S erzeugt (vergleiche Fig. 9). Diese Transistoren werden so miteinander verschaltet, daß ein "natürlicher" Baustein mit drei Anschlüssen entsteht, der also zu einem üblichen Feldeffekttransistor hinsichtlich seiner Anschlüsse vollständig kompatibel ist, ohne zusätzliche externe Bauelemente zu benöti-

·gen, wobei sich dieser Baustein jedoch durch einen wesentlich erhöhten Ausgangswiderstand $r_d$ auszeichnet.

Um diesen Ausgangswiderstand $r_d$ erhöhen zu können, muß der Transistor $T_2$ mit einer Gate-Spannung $U_{gT2}$ = constant gegenüber der Source-Elektrode S des Transistors $T_1$ betrieben werden (das bedeutet keine Änderung von $U_{dT2}$), das heißt $r_{dT1}$ wirkt sich nicht aus. Der Transistor $T_1$ muß in Sättigung betrieben werden, damit der Ausgangswiderstand $r_{dT1}$ möglichst hoch und somit die angestrebte Erhöhung des Ausgangswiderstands $r_d$ möglichst effektiv wird.

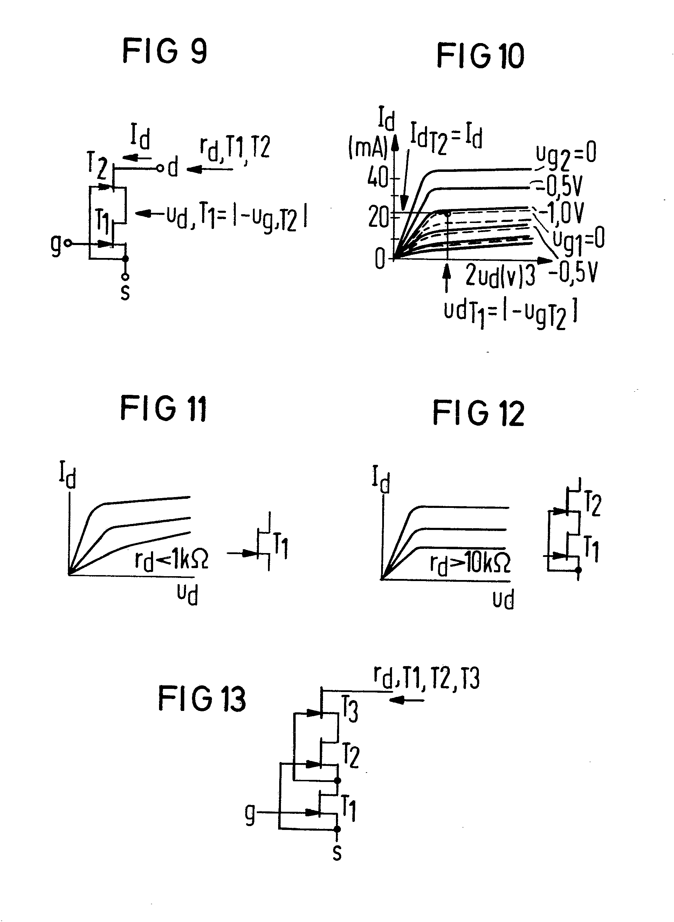

Aus Bild 10 ist zu ersehen, daß bei Erhöhung der Steilheit $g_{mo,T2}$ des Transistors $T_2$ über die Steilheit $g_{mo,T1}$ gemäß Fig. 9 folgende Beziehung vorliegen muß:

$$I_{d,T2} = I_{d,T1}.$$

Der Drain-Strom des Transistors $T_2$ hat also den gleichen Wert wie der Drain-Strom des Transistors $T_1$.

Wegen $g_{mo,T2} > g_{mo,T1}$ folgt für den in Sättigung betriebenen Drain-Strom des Transistors $T_1$, also für $I_d = I_{dss,T1}$:

$$I_{d,T2} \ (U_{g,T2} < 0) = I_{d,T1} \ (U_{g,T1} = 0) = I_{dss,T1}.$$

Damit wird automatisch die Drain-Spannung $U_{d,T1}$ auf $|-U_{d,T2}|$ angehoben.

Praktische Messungen haben nun ergeben, daß sich mit einem Gate-Flächenverhältnis, das etwa dem Steilheitsverhältnis von Feldeffekttransistoren zueinander entspricht, mit den Werten $A_{gT1} : A_{gT2} = 1 : 3 \ldots 1 : 4$

0048885
80 P 1165 E

($A_{gTi}$ = Gate-Fläche des Transistors $T_i$) Erhöhungen des Ausgangswiderstands $r_d$ auf über 10 k$\Omega$ erzielen lassen, wenn zwei Transistoren $T_1$ und $T_2$ entsprechend Bild 9 zusammengeschaltet sind. Bei einem normalen GaAs-Feldeffekttransistor beträgt der Ausgangswiderstand allenfalls 1 k$\Omega$. Diese Verhältnisse sind in den Fig. 11 und 12 gezeigt, wobei Fig. 11 einem normalen GaAs-Feldeffekttransistor entspricht und Fig. 12 die Kennlinienschar für das Ausführungsbeispiel der Fig. 9 darstellt.

Die Erzielung des nötigen Steilheitsverhältnisses der Feldeffekttransistoren zueinander muß nicht unbedingt über das Gate-Flächenverhältnis, was konstante Kanaldotierung voraussetzt, erfolgen. Das passende Steilheitsverhältnis kann ebenso bei gleicher Geometrie der Transistoren mit jedoch unterschiedlicher Kanaldotierung erreicht werden.

Weitere starke Erhöhungen des Ausgangswiderstands $r_d$ sind prinzipiell durch eine Serienschaltung eines dritten Transistors $T_3$ möglich; jedoch müßte hier die Steilheit $g_{mo,T3}$ des Transistors $T_3$ unproportional hoch gewählt werden, was einen hohen Gate-Flächenbedarf bedeuten würde, um eine ausreichend hohe Spannung $U_{d,T2}$ des Transistors $T_2$ zu erhalten.

Fig. 13 zeigt eine weitere Möglichkeit, wie der Ausgangswiderstand $r_d$ durch einen zusätzlichen dritten Transistor $T_3$ erhöht werden kann. Mit $g_{mo,T1} < g_{mo,T2} = g_{mo,T3}$, also gleicher Steilheit der Transistoren $T_2$ und $T_3$ folgt:

$$r_{d,T1,T2,T3} \approx 2 \cdot r_{d,T1,T2}.$$

Es ergibt sich ein günstiges Gate-Flächenverhältnis für Schaltung nach Fig. 13 mit

$$A_{gT1} : A_{gT2} : A_{gT3} = 1 : 3 : 3 \ldots 1 : 4 : 4$$

Praktisch aufgebaute Verstärkerschaltungen mit Transistoren entsprechend dem Ausführungsbeispiel der Fig. 13 liefern auch für eine aktive Last Verstärkungsfaktoren über 100 bei offener Schleife und Bandbreiten über 1,5 GHz.

13 Figuren
7 Patentansprüche

0048885

Patentansprüche

1. Transistor-Schaltung mit erhöhtem Ausgangswiderstand, bei der wenigstens zwei Transistoren mit parallelen Steuerelektroden in Reihe liegen, d a d u r c h g e k e n n z e i c h n e t , daß zwischen den Eingangs- und/oder Steuerelektroden der Transistoren Einrichtungen sind, die den Ausgangswiderstand der Schaltung steigern.

2. Transistor-Schaltung nach Anspruch 1, d a d u r c h g e k e n n z e i c h n e t , daß die Einrichtungen Widerstände zwischen den Steuerelektroden sind.

3. Transistor-Schaltung nach Anspruch 1, d a d u r c h g e k e n n z e i c h n e t , daß die Einrichtungen Dioden in Reihe zwischen den Steuerelektroden sind.

4. Transistor-Schaltung nach einem der Ansprüche 1 bis 3, d a d u r c h g e k e n n z e i c h n e t , daß die Transistoren Feldeffekttransistoren in Source-Folger-Schaltung sind.

5. Transistor-Schaltung nach Anspruch 4, d a d u r c h g e k e n n z e i c h n e t , daß die Feldeffekttransistoren GaAs-Feldeffekttransistoren sind.

6. Transistor-Schaltung nach Anspruch 5, d a d u r c h g e k e n n z e i c h n e t , daß die Eingangselektrode eines vorgeschalteten GaAs-Feldeffekttransistors mit der Steuerelektrode des nachgeschalteten GaAs-Feldeffekttransistors verbunden ist.

7. Transistor-Schaltung nach einem der Ansprüche 1 bis 6, d a d u r c h g e k e n n z e i c h n e t , daß die Transistoren untereinander verschiedene Geometrie bei konstanter Kanaldotierung beziehungsweise gleiche
Geometrie bei unterschiedlicher Kanaldotierung zur Erzielung des erforderlichen Steilheitsverhältnisses aufweisen.

**FIG 1**

**FIG 2**

**FIG 4**

**FIG 3**

**FIG 5**

**FIG 6**

**FIG 7**

**FIG 8**

## FIG 9

$r_d, T1, T2$

$-u_d, T1 = |-u_{g,T2}|$

## FIG 10

$I_d$ (mA)

$I_{dT2} = I_d$

$u_{g2} = 0$
$= 0,5V$
$-1,0V$
$u_{g1} = 0$
$-0,5V$

40

20

0

$2 u_d (v) 3$

$u_{dT1} = |-u_{gT2}|$

## FIG 11

$I_d$

$r_d < 1k\Omega$

$u_d$

$T1$

## FIG 12

$I_d$

$r_d > 10k\Omega$

$u_d$

$T2$

$T1$

## FIG 13

$r_d, T1, T2, T3$

$T3$

$T2$

$T1$

g

s